# EUROPÄISCHE PATENTSCHRIFT

(11) **EP 2 344 849 B1**
(45) Veröffentlichungstag und Bekanntmachung des Hinweises auf die Patenterteilung: **04.09.2019**
(21) Anmeldenummer: 09743892.3
(22) Anmeldetag: 27.10.2009
(51) Int. Cl.: G01F 23/24, G01F 23/26, G01F 25/00, H03K 17/945

(54) **VORRICHTUNG ZUR BESTIMMUNG UND/ODER ÜBERWACHUNG EINER PROZESSGRÖßE EINES MEDIUMS**
APPARATUS FOR DETERMINING AND/OR MONITORING A PROCESS VARIABLE FOR A MEDIUM
DISPOSITIF POUR LA DÉTERMINATION ET/OU LE CONTRÔLE D'UNE GRANDEUR DE PROCESSUS D'UN FLUIDE

(30) Priorität: 03.11.2008 DE 102008043412
(43) Veröffentlichungstag der Anmeldung: 20.07.2011
(73) Patentinhaber: Endress+Hauser SE+Co. KG, 79689 Maulburg (DE)
(72) Erfinder: WERNET, Armin, 79618 Rheinfelden (DE)
(74) Vertreter: Andres, Angelika Maria
(86) Internationale Anmeldenummer: PCT/EP2009/064128
(87) Internationale Veröffentlichungsnummer: WO 2010/060710

(56) Entgegenhaltungen:
- EP-A1- 1 067 368
- WO-A1-2008/040746
- DE-A1- 19 954 267
- DE-A1-102004 047 413
- US-A- 4 416 153

## Beschreibung

Die Erfindung bezieht sich auf eine Vorrichtung zur Bestimmung und/oder Überwachung mindestens einer Prozessgröße eines Mediums. Bei der Prozessgröße handelt es sich um den Füllstand.

Im Stand der Technik ist es beispielsweise bekannt, den Füllstand eines Mediums zu überwachen, indem erkannt wird, ob durch das Medium ein elektrischer Kontakt zwischen einer Sondenelektrode und der Wandung eines leitfähigen Behälters oder einer zweiten Elektrode besteht. Da es bei vielen Medien zu einem Ansatz an der Sondeneinheit kommen kann, werden sog. Guard- oder Referenzelektroden verwendet, welche auf dem gleichen elektrischen Potential wie die Sondenelektrode liegen und die Sondenelektrode umgeben (siehe z.B. DE 32 12 434 C2). Je nach Beschaffenheit des Ansatzes ist es jedoch möglich, dass es Schwierigkeiten gibt, das Guard- oder Referenzsignal passend zu erzeugen.

Somit besteht die Aufgabe der Erfindung darin, ein Messgerät vorzuschlagen, bei welchem über einen großen Bereich hinweg eine Unempfindlichkeit gegenüber Ansatz gegeben ist.

Die Erfindung löst die Aufgabe mit einer Vorrichtung zur Bestimmung und/oder Überwachung mindestens einer Prozessgröße eines Mediums, mit mindestens einer Auswerteeinheit, welche das Überschreiten und/oder Unterschreiten eines vorgebbaren Grenzwertes der Prozessgröße durch das Medium überwacht und/oder signalisiert, und mit mindestens einer Speichereinheit, in welcher mindestens einer Eigenschaft des Mediums zugeordnete Grenzwerte der Prozessgröße hinterlegt sind, und wobei die Auswerteeinheit ausgehend von einer Aussage über die Eigenschaft des Mediums für die Bestimmung und/oder Überwachung der Prozessgröße aus der Speichereinheit den hinterlegten Grenzwert verwendet, welcher der Eigenschaft des Mediums zugeordnet ist. Bei dem Messgerät handelt es sich somit um einen sog. Grenzstandschalter, bei welchem der Grenzwert für das Erzeugen des Schaltersignals für das jeweilige Medium aus einer Speichereinheit ausgewählt wird. Dafür wird mindestens eine Eigenschaft des Mediums ermittelt. Somit lässt sich der Grenzwert für den Messwert dann bezogen auf das jeweilige Medium so festlegen, dass insbesondere ein Ansatz am Messgerät das sichere Schalten, also das Anzeigen des Erreichen bzw. Unterschreitens des Grenzwertes, nicht verhindert. Da ein Ansatz im Allgemeinen das Messsignal verfälscht und somit eine falsche Prozessgröße vorspiegelt, ist der Grenzwert vorzugsweise so gelegt, dass er außerhalb des Bereichs für das Messsignal liegt, welcher durch den Ansatz erreichbar wäre. Die Vorrichtung kann dabei ein kapazitives oder konduktives Füllstandsmessgerät oder beispielsweise ein auf der Vibronik beruhendes Messgerät (Schwinggabel oder Einstab oder Membranschwinger) sein.

Mit anderen Worten: Das Erreichen eines Wertes der Prozessgröße wird dadurch erkannt, dass ein Messsignal einen entsprechenden (Grenz-)Wert erreicht, welcher dem Wert der Prozessgröße zugeordnet ist. Diese Zuordnung zwischen Prozessgröße und Messsignal ist jedoch von mindestens einer Eigenschaft des Mediums abhängig. Daher wird ausgehend von dieser Eigenschaft der passende Grenzwert für das Messsignal verwendet, wobei dieser Grenzwert für das Messsignal dem gewünschten Grenzwert der Prozessgröße entspricht. Damit geht einher, dass ein aufwendiger Abgleichvorgang entfallen kann, da der optimale Schaltpunkt aus den erfassten Mediumseigenschaften ermittelt bzw. berechnet wird und sich somit auch auf wechselnde Medien (z.B. auch Reinigungsvorgänge CIP, SIP) im Behälter oder Rohrsystem automatisch einstellt.

Die Erfindung wird mit dem Anspruch 1 definiert. Die abhängigen Ansprüche beschreiben weitere Ausführungsformen.

Die Erfindung beinhaltet, dass mindestens eine Elektronikeinheit vorgesehen ist, dass mindestens eine Sondeneinheit vorgesehen ist, welche die Elektronikeinheit mit einem Ansteuersignal beaufschlagt und von welcher die Elektronikeinheit ein Empfangssignal empfängt, und dass die Auswerteeinheit aus dem Empfangssignal eine Aussage über den Füllstand ermittelt. Das Ansteuersignal ist dabei beispielsweise eine Wechselspannung, weiche auf die Sondeneinheit oder zumindest einen Bestandteil der Sondeneinheit gegeben wird, und das Empfangssignal ist das Stromsignal oder eine dazu korrespondierende elektrische Spannung, welche von der Sondeneinheit oder zumindest einem Bestandteil der Sondeneinheit abgreifbar ist. In dieser Ausgestaltung handelt es sich somit insbesondere um einen kapazitiven oder konduktiven Füllstandschalter. Im Stand der Technik werden solche Grenzschalter entweder mit einem Standardabgleich ausgeliefert, der das ganze Produkt- bzw. Mediumsspektrum ohne Nachabgleich abdecken kann, oder aber der Kunde muss selber das Gerät Vorort, d.h. im eingebauten Zustand per Abgleich (z.B. über einen Potentiometer) auf sein zu messendes Medium abgleichen. Ein Neuabgleich stellt dabei einen Zusatzaufwand da, da insbesondere der dem Grenzstand zugeordnete Füllstand des Mediums angefahren werden muss, und ist daher nicht wünschenswert. Ein fertigungsseitiger Standardabgleich hat im Allgemeinen den Nachteil, dass ein derartig abgeglichenes Messgerät bei Verschmutzungen der Sondeneinheit bzw. im Fall von an der Sondeneinheit anhaftendem Ansatz relativ schnell eine Fehlschaltung auslöst.

Die Auswerteeinheit ermittelt aus dem Empfangssignal eine Aussage über die elektrische Leitfähigkeit des Mediums.

Eine Ausgestaltung beinhaltet, dass die Sondeneinheit mindestens eine Sensorelektrode und eine Guardelektrode aufweist. Eine weitere Bezeichnung für Guardelektrode ist Kompensationselektrode, wobei die Bezeichnung auch die jeweilige Verwendung bzw. der Art der Beaufschlagung mit einem oder mehreren Signalen widerspiegelt. Die Guardelektrode dient in eine Ausgestaltung als Referenzelektrode, über welche der Belastungszustand an der Sondeneinheit durch das Medium ständig überwacht wird, wobei beispielsweise über das Verhältnis der Referenzspannung - also die Spannung, welche an der Referenzelektrode abgreifbar ist - zur Messspannung - also die Spannung, welche als Empfangssignal nach der Beaufschlagung mit dem Ansteuersignal von der Sensorelektrode abgreifbar ist - eine Frei- oder Bedecktmeldung erzeugt, d.h. das Unter- bzw. Überschreiten des Grenzwerts wird angezeigt.

Eine Ausgestaltung sieht vor, dass die Guardelektrode im Wesentlichen zylindrisch ausgestaltet ist, und dass die Sensorelektrode innerhalb der im Wesentlichen zylindrisch ausgestalteten Guardelektrode angeordnet ist. Die Guardelektrode dient dabei in einer Ausgestaltung insbesondere auch als Referenzelektrode. Der hier beschriebene Aufbau entspricht dabei insbesondere einer in der Offenlegungsschrift DE 10 2007 003 887 A1.

Eine Ausgestaltung sieht vor, dass die Auswerteeinheit ausgehend von dem Empfangssignal, welches mit dem Unterschreiten des Grenzwerts einhergeht, auf einen Grad der Bedeckung der Sondeneinheit mit Ansatz schließt. Durch den Ansatz ergibt sich zumeist im vom Medium unbedeckten Zustand ein Signal bzw. eine Messspannung, welche sich von dem Signal bzw. der Spannung unterscheidet, welches bzw. welche dem eigentlichen Freizustand entspricht. Dabei wirkt sich auch die Stärke des Ansatzes deutlich aus. Daher kann beispielsweise aus einer Änderung des Ansatz-Signals für den unbedeckten Zustand auf eine zunehmende Ansatz-Stärke geschlossen werden, so dass auch auf eine vorausschauende Wartung (predictive maintenance) geschlossen werden kann. Liegt ein Messwert sehr nahe am Schaltpunkt bzw. Grenzwert und verharrt dort, so kann eine Warnmeldung ausgegeben werden, die zum Reinigen der Sonde auffordert.

Die Erfindung wird anhand der nachfolgenden Zeichnungen näher erläutert. Es zeigt:
Fig. 1: eine schematische Darstellung der Anwendung eines erfindungsgemäßen Messgerätes, und
Fig. 2: eine schematische Darstellung eines Abschnitts einer Sondeneinheit.

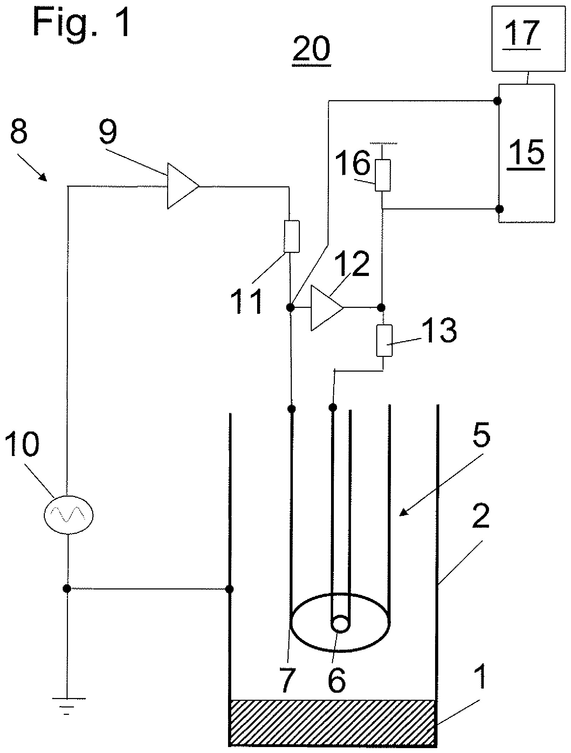

In der Fig. 1 wird der Füllstand eines Mediums 1 innerhalb eines Behälters 2 überwacht. Bei dem Medium 1 handelt es sich dabei vorzugsweise um eine elektrisch leitfähige Flüssigkeit. Die Anwendung bei elektrisch nicht-leitfähigen Medien ist ebenfalls möglich. Das Messgerät besteht aus einer Elektronikeinheit 8 und einer Sondeneinheit 5. In der praktischen Ausgestaltung ist die Sondeneinheit 5 dabei vorzugsweise derartig in die Wandung des Behälters 2 eingebaut, dass die Wandung direkt mit ihr abschließt. Bei dem Behälter 2 handelt es sich beispielsweise auch um ein Rohr, durch welches das Medium 1 strömt; unter Behälter sei somit jegliche Art von Struktur verstanden, welche ein Medium zumindest zeitweise aufnimmt. Die Wandung des Behälters 2 ist hier als Masseelektrode ausgestaltet, d.h. sie ist elektrisch leitend mit einem Massepotential verbunden. Alternativ wird eine zweite Elektrode in den Behälter 2 eingebracht. Ebenfalls mit Masse ist eine Signalquelle 10 verbunden, welche insbesondere ein elektrisches Wechselspannungssignal als Ansteuersignal erzeugt, welches an die Sensorelektrode 6 gegeben wird. Erreicht das - elektrisch leitfähige - Medium 1 einen Füllstand, der durch die Ausgestaltung der Sondeneinheit 5 und dessen Position innerhalb oder an dem Behälter 2 vorgegeben ist, so wird ein elektrischer Kontakt zwischen der Sensorelektrode 6 und der Wandung des Behälters 2 hergestellt, was dazu führt, dass sich beispielsweise der Strom, welcher sich von der Sensorelektrode 6 als Empfangssignal abgreifen lässt, ändert.

Eine Problematik tritt auf, wenn beispielsweise das Medium 1 sich wieder absenkt und dabei an der Sondeneinheit 5 als Ansatz haften bleibt. Ist beispielsweise die gesamte Wandung des Behälters 2 elektrisch leitend mit Masse verbunden und erstreckt sich der Ansatz von der Sensorelektrode 6 bis zur Wandung, so erfolgt eine Falschanzeige, da immer noch der Bedeckt-Zustand angezeigt wird. Um dieser Ansatzproblematik zu entgehen, ist die sog. Guardelektrode 7 vorgesehen, welche vorzugsweise die Sensorelektrode 6 koaxial zumindest in dem Bereich, in welchem die Sensorelektrode in Kontakt mit dem Medium 1 kommt, umgibt. Zwischen der Sensorelektrode 6 und der Guardelektrode 7 ist dabei üblicherweise ein Isolator in der Sondeneinheit 5 vorgesehen. Diese Guardelektrode 7 wird hier über eine erste Verstärkungseinheit 9 mit einem Guardsignal beaufschlagt. Dabei haben das Sondensignal und das Guardsignal vorzugsweise die gleiche Phase und die gleiche Amplitude. Befindet sich Ansatz an der Sondeneinheit 5, so treibt die Guardelektrode 7 einen Wechselstrom zur Gegenelektrode (dies ist hier beispielsweise die geerdete Wandung des Behälters 2 oder in einer alternativen Ausgestaltung eine zweite zusätzliche Elektrode) und hebt den elektroden-bedeckenden Ansatz idealerweise auf das elektrische Potential, auf welchem die Guardelektrode 7 liegt. Ein Stromfluss von der Sondenelektrode 6 zur Gegenelektrode 2 wird somit vermieden, da der umgebende Ansatz um die Sondenelektrode durch die Guardelektrode auf das gleiche elektrische Potential angehoben wird.

Das Signal der Signalquelle 10 - dabei kann es sich um ein beliebiges Wechselsignal handeln - wird über die Verstärkungseinheit 9 über ein Begrenzungselement 11 - hier ein ohmscher Widerstand - auf die Guardelektrode 7 gegeben. Der Widerstand des Begrenzungselements 11 ist größer als der Innenwiderstand der Verstärkungseinheit 9 zu wählen. Durch das Begrenzungselement 11 wird verhindert, dass der Verstärker 9 in die Begrenzung kommt. Das Guardsignal wird vorzugsweise als Referenzsignal bzw. als Referenzspannung für die Auswertung bzw. Bestimmung des Füllstandes der Auswerteeinheit 15 zugeführt, wo es beispielsweise durch einen Analog-Digital-Wandler, welcher ggf. auch Bestandteil eines Mikroprozessors ist, digitalisiert wird. Weiterhin wird das Guardsignal einer Verstärkungseinheit zugeführt, welche hier als Trennungseinheit 12 - insbesondere auch mit der Aufgabe eines Impedanzwandlers - zur Verhinderung der Rückwirkung dient. Die Verstärkung dieser Trenneinheit 12 ist beispielsweise gleich Eins gesetzt. Das Guardsignal erreicht über das Sondenstrombegrenzungselement 13 als Ansteuersignal die Sensorelektrode 6. Bei dem Sondenstrombegrenzungselement 13 handelt es sich dabei vorzugsweise auch um einen ohmschen Widerstand, welcher verhindert, dass der Sondenstrom bei sehr leitfähigen Medien zu groß wird und damit beispielsweise außerhalb des Bereichs des Analog/Digitalwandlers liegt. Das Ansteuersignal wird ggf. auch der Auswerteeinheit 15 zugeführt, um beispielsweise ebenfalls digitalisiert zu werden. Bei der Auswertung wird in einer Ausgestaltung das Verhältnis zwischen dem Guardsignal und dem Empfangssignal ausgewertet bzw. mit dem vorgebbaren Grenzwert verglichen.

Die Auswerteeinheit 15 ist erfindungsgemäß mit einer Speichereinheit 17 verbunden, in welcher Grenzwerte hinterlegt sind. Die Grenzwerte sind dabei beispielsweise über eine Formel oder in Form einer Tabelle hinterlegt. Die Grenzwerte sind dabei vorzugsweise in Abhängigkeit von mindestens einer Eigenschaft der zu messenden Medien abgelegt, hier handelt es sich insbesondere um die elektrische Leitfähigkeit der Medien. Je nach dem ermittelten Leitfähigkeitswert wird dann der dazu passende Grenzwert aus der Speichereinheit 17 entnommen und in Abhängigkeit von diesem Wert wird dann im laufenden Betrieb das Erreichen bzw. Unterschreiten des mit dem grenzwert verbundenen Füllstands des Mediums signalisiert.

Um die Daten zu erhalten, werden vorzugsweise bei der Fertigung Messdaten für den freien und für den bedeckten Fall ohne Ansatz aufgenommen. Vorzugsweise lassen sich die Messdaten mit einer mathematischen Funktion beschreiben. Um ein sicheres Schalten zu gewährleisten, wird in einem definierten Abstand über der Bedecktlinie eine Schaltpunktlinie vorgegeben und als Funktion oder als Einzeldaten in der Speichereinheit 17 abgelegt. Dies geschieht beispielsweise werksseitig für bestimmte Sondengeometrien.

Es zeigt sich, dass die Referenzspannung, d.h. die von der hier als Referenzelektrode dienenden Guardelektrode 7 abnimmt je leitfähiger das Medium ist.

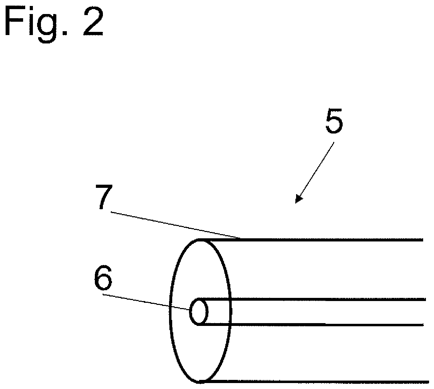

In der Fig. 2 ist der Aufbau der Sondeneinheit 5 verdeutlicht: die Guard- bzw. Referenzelektrode 7 ist zylindrisch ausgestaltet und umgibt die Sensorelektrode 6, welcher hier in ihrer Mitte angeordnet ist. Dargestellt ist dabei die Endfläche der Sondeneinheit 5, in welcher die Guardelektrode 7 als Umrandung der Fläche erscheint, in deren Mitte die Sensorelektrode 6 mündet.

Die Inbetriebnahme eines erfindungsgemäßen Messgerätes erfolgt somit beispielsweise durch folgende Schritte:
Die Auswerteeinheit 15 arbeitet zunächst mit dem Grenzwert, der den Unterschied zu Luft repräsentiert, der also durch das Bedecken der Sondeneinheit 5 mit jedem Medium ein Signal auslöst. Kommt es zu einer Bedeckung durch das Medium, so wird über die Guardelektrode 7 eine Impedanz- bzw. eine Leitfähigkeitsmessung des Mediums vorgenommen, d.h. es wird das erste Mal festgestellt, um was für ein Medium es sich bzgl. der Messung handelt. Aus der ermittelten Guardspannung bzw. aus der Leitfähigkeitsmessung wird dann aus der Speichereinheit 17 der zugehörige Grenzwert entnommen. Das Sondensignal wid in Bezug auf den ermittelten Grenzwert ausgewertet und führt zu einer Frei- oder einer Bedecktmeidung des Sensors. Der Grenzwert ist dabei so gesetzt, dass auch ein Ansatz des Mediums nicht verhindert, dass beim Unterschreiten des dem Grenzwert zugehörigen Füllstands ein Freisignal erzeugt wird.

Einige Vorteile sind somit, dass zum einen kein bewusst hervorgerufener Abgleich erforderlich ist, sondern dass der Abgleich und die Optimierung hin auf das vorliegende Medium im direkten Betrieb selbständig vom Messgerät vorgenommen wird, und zum anderen, dass der Grenzwert für das Medium spezifisch ist und derartig vorgegeben ist, dass ein Ansatz das Schalten des Messgerätes nicht beeinträchtigt.

### Bezugszeichenliste

- 1: Medium
- 2: Behälter
- 5: Sondeneinheit
- 6: Sensorelektrode
- 7: Guardelektrode
- 8: Elektronikeinheit
- 9: Verstärkungseinheit
- 10: Signalquelle
- 11: Begrenzungselement
- 12: Trennungseinheit
- 13: Sondenstrombegrenzungselement
- 15: Auswerteeinheit
- 16: Messwiderstand für Sensorelektrodenstrom
- 17: Speichereinheit
- 20: Messeinheit

## Patentansprüche

1. Vorrichtung zur kapazitiven oder konduktiven Bestimmung und/oder Überwachung mindestens des Füllstands eines Mediums (1) innerhalb eines Behälters (2) mit mindestens einer Sondeneinheit (5) und mit mindestens einer Elektronikeinheit (8) zur Beaufschlagung der Sondeneinheit (5) mit einem Ansteuersignal zum Empfangen eines Empfangssignals von der Sondeneinheit (5), mit mindestens einer Auswerteeinheit (15) zum Überwachen und/oder Signalisieren des Überschreitens und/oder Unterschreitens eines vorgebbaren Grenzwertes des Füllstands, mit mindestens einer Speichereinheit (17), in welcher mindestens der elektrischen Leitfähigkeit des Mediums (1) zugeordnete Grenzwerte des Füllstands über eine Formel oder in Form einer Tabelle hinterlegt sind,
wobei die Auswerteeinheit (15) dazu ausgestaltet ist, aus dem Empfangssignal eine Aussage über den Füllstand zu ermitteln,
aus dem Empfangssignal eine Aussage über die elektrische Leitfähigkeit des Mediums zu ermitteln,
und ausgehend von dem ermittelten Wert für die elektrische Leitfähigkeit des Mediums (1) für die Bestimmung und/oder Überwachung des Füllstands aus der Speichereinheit (17) den hinterlegten Grenzwert zu verwenden, welcher dem ermittelten Wert für die elektrische Leitfähigkeit des jeweiligen Mediums (1) zugeordnet ist.

2. Vorrichtung nach dem Anspruch 1, **dadurch gekennzeichnet,**
**dass** die Sondeneinheit (5) mindestens eine Sensorelektrode (6) und eine Guardelektrode (7) aufweist.

3. Vorrichtung nach Anspruch 2, **dadurch gekennzeichnet,**
**dass** die Guardelektrode (7) im Wesentlichen zylindrisch ausgestaltet ist, und
**dass** die Sensorelektrode (6) innerhalb der im Wesentlichen zylindrisch ausgestalteten Guardelektrode (7) angeordnet ist.

4. Vorrichtung nach einem der Ansprüche 1-3 **dadurch gekennzeichnet,**
**dass** die Auswerteeinheit (15) dazu ausgestaltet ist, ausgehend von dem Empfangssignal, welches mit dem Unterschreiten des Grenzwerts einhergeht, auf einen Grad der Bedeckung der Sondeneinheit (5) mit Ansatz zu schließen.

## Claims

1. Apparatus for the capacitive or conductive determination and/or monitoring at least of the level of a medium (1) in a vessel (2) with at least a probe unit (5) and at least an electronics unit (8) designed to subject the probe unit (5) to a control signal for the reception of a reception signal from the probe unit (5), with at least an evaluation unit (15) to monitor and/or signal if a predefined limit value for the level is exceeded or undershot,
with at least a memory unit (17) in which at least level limit values assigned to the electrical conductivity of the medium (1) are saved via a formula or in the form of a table,
wherein the evaluation unit (15) is designed to determine
information about the level from the reception signal,
information about the electrical conductivity of the medium from the reception signal,
and - on the basis of the value determined for the electrical conductivity of the medium (1) - to use the limit value saved in the memory unit, which is assigned to the value determined for the electrical conductivity of the medium, in order to determine and/or monitor the level of the medium (1).

2. Apparatus as claimed in Claim 1,
**characterized in that**
the probe unit (5) has at least one sensor electrode (6) and one guard electrode (7).

3. Apparatus as claimed in Claim 2,
**characterized in that**
the guard electrode (7) is essentially cylindrical in design,
and
**in that** the sensor electrode (6) is arranged inside the guard electrode (7), which is essentially cylindrical in design.

4. Apparatus as claimed in one of the Claims 1-3,
**characterized in that**
the evaluation unit (15) is designed to infer the degree to which the probe unit (5) is covered with deposit build-up on the basis of the reception signal which is associated with the undershooting of the limit value.

## Revendications

1. Dispositif destiné à la détermination capacitive ou conductive et/ou à la surveillance au moins du niveau d'un produit (1) à l'intérieur d'un réservoir (2) avec au moins une unité de sonde (5) et avec au moins une unité électronique (8) destinée à l'alimentation de l'unité de sonde (5) avec un signal de commande pour la réception d'un signal de réception de l'unité de sonde (5), avec au moins une unité d'exploitation (15) destinée à la surveillance et/ou la signalisation du dépassement par excès et/ou du dépassement par défaut d'un seuil prédéfinissable du niveau,
avec au moins une unité de mémoire (17), dans laquelle sont enregistrées des seuils de niveau au moins affectés à la conductivité électrique du produit (1), au moyen d'une formule ou sous la forme d'un tableau,
l'unité d'exploitation (15) étant conçue de telle sorte à déterminer à partir du signal de réception une information sur le niveau du produit,
à partir du signal de réception une information sur la conductivité électrique du produit,
et de telle sorte à utiliser,
à partir de la valeur déterminée pour la conductivité électrique du produit (1) en vue de la détermination et/ou de la surveillance du niveau, le seuil enregistré dans l'unité de mémoire (17), seuil auquel est attribué la valeur déterminée pour la conductivité électrique du produit (1) concerné.

2. Dispositif selon la revendication 1,
**caractérisé**
**en ce que** l'unité de sonde (5) comporte au moins une électrode de capteur (6) et une électrode de protection (7).

3. Dispositif selon la revendication 2,
**caractérisé**
**en ce que** l'électrode de protection (7) est pour l'essentiel conçue de façon cylindrique,
et
**en ce que** l'électrode de capteur (6) est disposée à l'intérieur de l'électrode de protection (7) conçue pour l'essentiel de façon cylindrique.

4. Dispositif selon l'une des revendications 1 à 3,
**caractérisé**
**en ce que** l'unité d'exploitation (15) est conçue de telle sorte à déterminer, à partir du signal de réception, lequel est généré suite au passage sous le seuil, un degré de recouvrement de l'unité de sonde (5) avec un dépôt.
